# EUROPEAN PATENT APPLICATION

(11) **EP 4 167 391 A1**
(43) Date of publication of application: **19.04.2023**
(21) Application number: 21202421.0
(22) Date of filing: 13.10.2021
(51) Int. Cl.: H01R 13/53, H01R 13/648, H01R 13/533, H01R 24/50, H01R 12/73, G03F 7/20

(54) **ELECTRICAL CONNECTOR FOR HIGH POWER IN A VACUUM ENVIRONMENT AND METHOD**

(71) Applicant: ASML Netherlands B.V., 5500 AH Veldhoven (NL)
(72) Inventor: DAMEN, Johannes, Wilhelmus, 6021 CN Budel (NL); NIJSMANS, Nick, 5500 AH Veldhoven (NL); LÉNÁRT, Attila, 5500 AH Veldhoven (NL); DRIESSEN, Alexander, Barbara, Jacobus, Maria, 5500 AH Veldhoven (NL); VAN DIEM, Cornelus, Adrianus, Aloïsius, 5500 AH Veldhoven (NL); QUANTEN, Dirk, 5500 AH Veldhoven (NL); VAN KNIPPENBERG, Martinus, Wilhelmus, Hendrikus, 5500 AH Veldhoven (NL)
(74) Representative: ASML Netherlands B.V.

(57) **Abstract**

The disclosure provides an electrical connector for high power in a low pressure environment, the connector comprising: a male connection part (46) configured to be connected to a first power interface (60), a female connection part (48) for receiving the male connection part and configured to be connected to a second power interface (62), a first conductive shield (70) enclosing the male connection part and the female connection part, the first conductive shield being electrically connected to at least one of the male connection part and the female connection part, and an isolating part (80) enclosing the first conductive shield.

## Description

### FIELD

The present invention relates to an electrical connector and a method for use thereof. The connector is suitable to connect, for instance, printed circuit boards.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (resist) provided on a substrate.

To project a pattern on a substrate a lithographic apparatus may use electromagnetic radiation. The wavelength of this radiation determines the minimum size of features which can be formed on the substrate. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

An apparatus such as the EUV lithographic apparatus referenced above may function at relative high power. Voltages may be in the order of 1 kV or more. Current may be in the order of 1 to 60 Ampere or more. In addition, many components of the apparatus may be designed to operate in a low pressure environment. Low pressure herein may refer to pressures in the order of 50 mbar (5 kPa) and below. Some parts of the apparatus may operate at even lower pressures, in the order of 0.1 to 0.01 mbar (10 to 1 Pa).

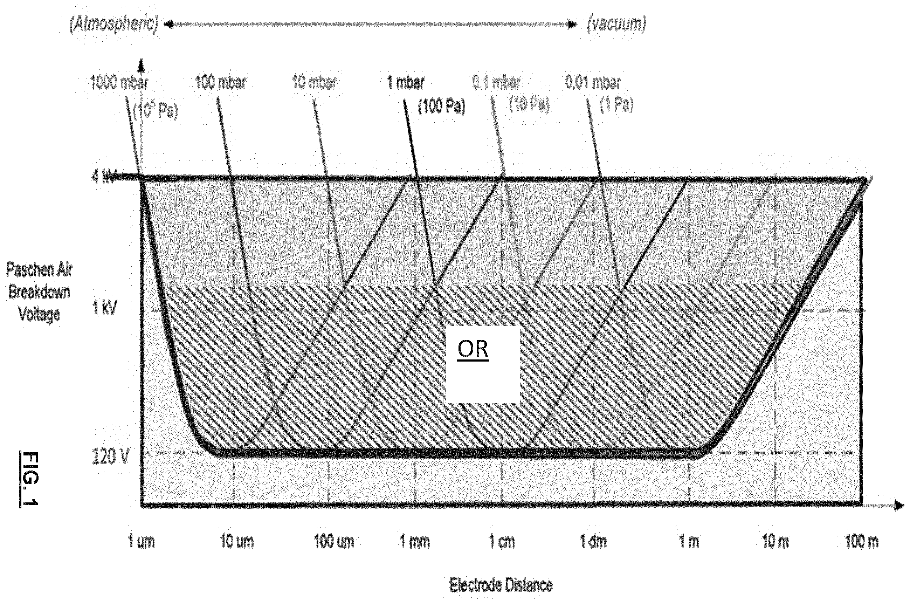

The electrical power as mentioned above is of such as magnitude, that electrical connections may run into problems related to Paschen's law. Paschen's law is an equation that gives the breakdown voltage, that is, the voltage necessary to start a discharge or electric arc, between two electrodes in a gas as a function of pressure and gap length. It is named after Friedrich Paschen who discovered it empirically in 1889. For a given gas, the voltage is a function only of the product of the pressure and gap length. The curve he found of voltage versus the pressure-gap length product is called Paschen's curve. He found an equation that fits these curves, which is now called Paschen's law. See Figure 1 for examples of Paschen's curve in air for various pressure levels. The graph of Figure 1 indicates breakdown voltage on the vertical axis with respect to electrode distance on the horizontal axis. Paschen breakdown is the outcome of an avalanche effect related with the ionization of a gas under electric stress.

Paschen found that breakdown voltage was described by the equation: *V_{B}* = *Bpd* / *[ln(Apd)* / *- ln{ln(1* + *1*/*gₛₑ)}].* Herein, *V_{B}* is the breakdown voltage in volts, *p* is the pressure in pascals, *d* is the gap distance in meters, *gₛₑ* is the secondary-electron-emission coefficient (the number of secondary electrons produced per incident positive ion), A is the saturation ionization in the gas at a particular *E*/*p* (electric field / pressure), and B is related to the excitation and ionization energies. The constants A and *B* are determined experimentally and found to be roughly constant over a restricted range of *E*/*p* for any given gas. For example, air with an *E*/*p* in the range of 450 to 7500 W(kPa·cm), A = 112.50 (kPa·cm)⁻¹ and *B* = 2737.50 V/(kPa·cm).

Paschen's law may, for instance, affect air trapped in pockets of electrical connectors when the pressure in the area surrounding the respective connector is reduced. Also, Paschen breakdown may result in electrical sparks or arcs from the connection to equipment parts relatively remote from the connection. The sparks may negatively influence the functioning of the connector or components, for instance by deteriorating isolation material. Ultimately, this may result in the breakdown of an entire module, with associated capital expenditure to replace the module and operational losses due to unwarranted downtime. In addition, Paschen breakdown may result in electrical sparks towards low voltage components on an outside of the apparatus causing a safety risk for operators due to the potential of an electric shock.

To complicate matters, startup of the EUV lithographic apparatus may take quite a while, typically a number of hours. To minimize the time for startup, the apparatus and its electrical components have been designed to be fully operational already during startup. Given the low pressure environment mentioned, for some electrical equipment and modules this includes being operational in an environment while the pressure may be changing from atmospheric (1 bar) down to operating pressure as exemplified above, or vice versa.

There is a need for electrical connections able to transfer relatively high power reliably and safely over a range of pressures, while avoiding Paschen breakdown. An example of operating range where conventional connectors may cause problems related to Paschen breakdown is provided by greyed-out area OR shown in Figure 1.
US-2011/134399 discloses a lithographic apparatus arranged to transfer a pattern onto a substrate comprising: a power supply; and an electrical connector comprising a laminate that comprises, in order, the following layers: a first conducting layer; a first flexible insulating layer; a conductor configured to carry an electrical current; a second flexible insulating layer; and a second conducting layer; wherein the electrical connector electrically connects the power supply to another component of the lithographic apparatus. The electrical connector is however limited in current, for instance to about 0.1 A. The connector is unsuitable for the operating range OR shown in Fig. 1.
US-8,130,359 B2 discloses a lithographic apparatus comprising a vacuum chamber and a controller. The vacuum chamber and the controller are configured to control an actuator of the optical device arranged in the vacuum chamber, the vacuum chamber comprising a hermetically sealed housing in which the controller is accommodated, the housing being provided with an electrical connection configured to electrically connect the controller to the optical device, the housing being connected to an exterior wall of the vacuum chamber via a fluid cooling channel configured to cool the controller.

The disclosure aims to provide an improved electrical connector which avoids some or all of the disadvantages associated with connectors currently available.

### SUMMARY

The present disclosure provides electrical connector for high power in a low pressure environment, the connector comprising:
a male connection part configured to be connected to a first power interface,
a female connection part for receiving the male connection part and configured to be connected to a second power interface,
a first conductive shield enclosing the male connection part and the female connection part, the first conductive shield being electrically connected to at least one of the male connector part, the female connector part, the first power interface and the second power interface, and an isolating part enclosing the first conductive shield.

In an embodiment, the connector comprises a second conductive shield enclosing the isolating part.

In an embodiment, the connector comprises a first end cap at least partly enclosing the first power interface, and a second end cap at least partly enclosing the second power interface.

In an embodiment, the first end cap and the second end cap together with the second conductive shield form an electrically closed enclosure of the male connection part, the female connection part, the first conductive shield and the isolating part.

In an embodiment, the first conductive shield being a metallic tubular shield.

In an embodiment, the isolating part is a tubular polymer element. The polymer may comprise a flexible rubber material. The isolating part may comprise a fluoropolymer elastomer selected from the group of copolymers of terpolymers of tetrafluoroethylene (TFE), hexafluoropropylene (HFP), vinylidene fluoride (VDF or VF2), vinylidene fluoride (VDF), hexafluoropropylene (HFP), and perfluoromethylvinylether (PMVE).

In an embodiment, high power includes a voltage exceeding 0.5 kV, or a voltage in the order of 1 kV or more.

In an embodiment, high power includes current exceeding 20 A, or current in the order of 40A or more.

According to another aspect, the disclosure provides a lithographic system comprising the electrical connector of claim 1.

The lithographic system may comprise at least a first module having the first power interface, and a second module comprising the second power interface, the electrical connector electrically connecting the first module and the second module.

According to another aspect, the disclosure provides a method for providing an electrical connector for high power in a low pressure environment, the method comprising the steps of:
providing a first power interface and a male connection part connected to the first power interface,
providing a second power interface and a female connection part connected to the second power interface,
enclosing one of the male connection part or the female connection part with a first conductive shield,
enclosing the first conductive shield with an isolating part,
connecting the male connection part to the female connection part,
wherein the first conductive shield is in electric communication with at least one of the male connection part, the female connection part, the first power interface and the second power interface.

In an embodiment, the method comprises the step of enclosing the isolating part with a second conductive shield.

In an embodiment, the method comprises the step of arranging a first end cap at least partly enclosing the first power interface, and arranging a second end cap at least partly enclosing the second power interface.

In an embodiment, the method comprises the step of connecting the male connection part to the female connection part. The method may comprise the step of compressing the isolating part between the first power interface and the second power interface.

In an embodiment, the method comprises the step of operating the connected male connection part and female connection part at a voltage exceeding 0.5 kV, for instance a voltage in the order of 1 kV or more, and/or a current exceeding 20 A, for instance a current in the order of 40A or more.

The connector and method of the disclosure enable to operate over a relatively wide range of pressures and at high voltage and current while avoiding Paschen breakdown. Thus, the connector and method of the disclosure are able to safely and reliably operate even during startup of the EUV lithography apparatus and over the entire operating range as envisaged. The connector of the disclosure may be referred to as a Paschen-safe electrical connector. In addition, the connector is relatively simple and robust and consequently cost effective both from a perspective of capital expenditure and operating expenditure.

### BRIEF DESCRIPTION OF THE DRAWINGS

Embodiments of the invention will now be described, by way of example only, with reference to the accompanying schematic drawings, in which:
- Figure 1 depicts a diagram indicating examples of Paschen's curve for air at various pressure levels, with Paschen breakdown voltage on the vertical axis versus electrode distance on the horizontal axis;
- Figure 2 depicts a lithographic system comprising a lithographic apparatus and a radiation source;
- Figure 3 depicts a cross-section of an embodiment of a connector according to the disclosure; and
- Figure 4 depicts a cross-section of another embodiment of a connector according to the disclosure.

### DETAILED DESCRIPTION

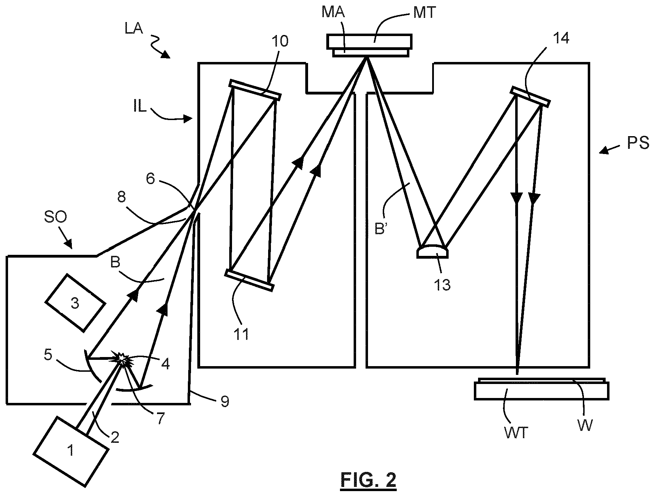

Figure 2 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 2, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS. Low pressure herein may refer to pressures in the order of 50 mbar (5 kPa) and below. Parts of the apparatus, including for instance the part comprising the radiation source, may operate at lower pressures, in the order of 0.1 to 0.01 mbar (10 to 1 Pa).

The radiation source SO shown in Figure 2 is, for example, of a type which may be referred to as a laser produced plasma (LPP) source. A laser system 1, which may, for example, include a CO₂ laser, is arranged to deposit energy via a laser beam 2 into a fuel, such as tin (Sn) which is provided from, e.g., a fuel emitter 3. Although tin is referred to in the following description, any suitable fuel may be used. The fuel may, for example, be in liquid form, and may, for example, be a metal or alloy. The fuel emitter 3 may comprise a nozzle configured to direct tin, e.g. in the form of droplets, along a trajectory towards a plasma formation region 4. The laser beam 2 is incident upon the tin at the plasma formation region 4. The deposition of laser energy into the tin creates a tin plasma 7 at the plasma formation region 4. Radiation, including EUV radiation, is emitted from the plasma 7 during de-excitation and recombination of electrons with ions of the plasma.

The EUV radiation from the plasma is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO.

Although Figure 2 depicts the radiation source SO as a laser produced plasma (LPP) source, any suitable source such as a discharge produced plasma (DPP) source or a free electron laser (FEL) may be used to generate EUV radiation.

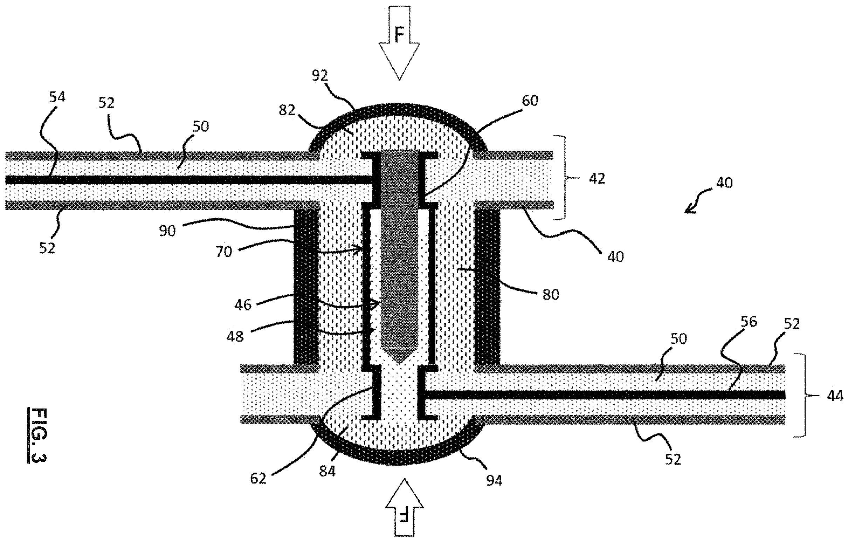

Referring to Figure 3, a connector 40 according to the present disclosure may electrically connect a first module 42 and a second module 44. One or both of the modules may be, or may comprise, a printed circuit board (PCB). One of the modules, for instance the first module 42, may be provided with a male connector part 46. The other module may be provided with a female connector part 48. The female connector part 48 is shaped to receive and engage with the male connector part 46.

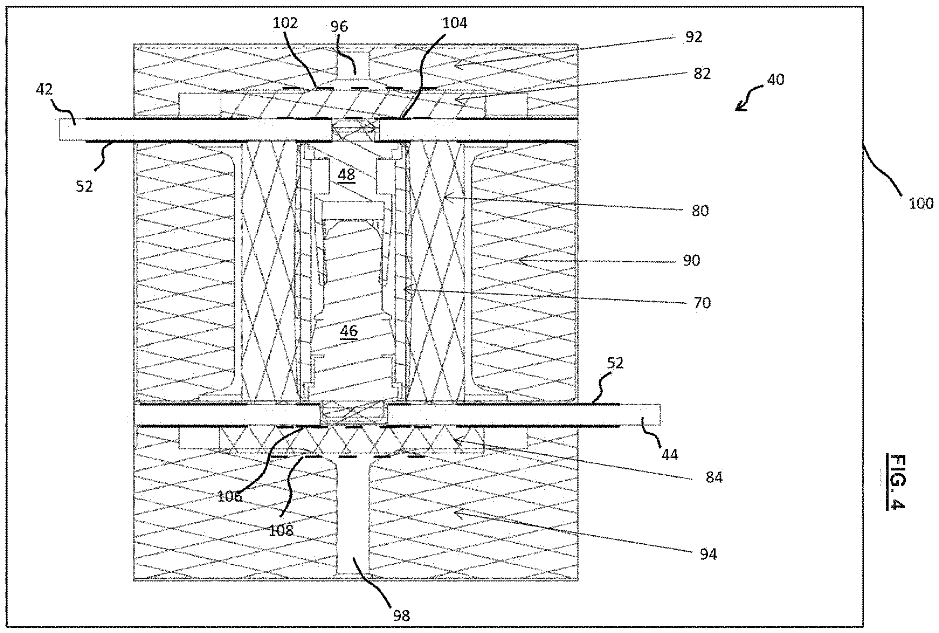

The first and second printed circuit boards 42, 44 may comprise a carrier 50. The carrier 50 may comprise an isolating and relatively inflexible material, to provide structural strength and electrical isolation. Outside surfaces of the typically plate shaped carrier 50 may be provided with a coating 52 of conducting material. The coating 52 can be connected to a reference voltage, typically referred to as ground or earth. The boards 42, 44 may also comprise a signal transfer section, schematically indicated as first signal section 54 and second signal section 56 respectively. In reality, the signal transfer sections 54, 56 may comprise a number of signal processing units as generally included in a printed circuit board to provide the board with a certain predetermined functionality. The first signal transfer section 54 may connect to the male connector part 46 via a first signal interface 60. The second signal transfer section 56 may connect to the female connector part 48 via a second signal interface 62. The first and second signal interface 60, 62 and the signal transfer sections 54, 56 are generally intended to transfer signal at high voltage and/or current. The first and second signal interfaces 60, 62 may also be referred to as first and second power interfaces. Please note that the figures are schematic representations only. The location of the interconnect of each PCB is inflexible. Other parts of the PCB may need to be flexible. The figures 3 and 4 show 54 as a high voltage conductor drawn as a single layer, but splitting up the conductor over multiple layers is also possible. The top and bottom coating layer 52 are connected to ground or earth.

The male connector part 46 and female connector part 48 may be enclosed by a first conductive shield 70. The first conductive shield may be cylindrical. The first conductive shield is made of an electrically conductive material, typical a metal closely related to or similar to the material of the male connector part 46 and/or the female connector part 48. The first conductive shield 70 may engage one or more of the male connector part 46, the female connector part 48, the first power interface 60 and the second power interface 62. In operation, the first conductive shield 70 is at the same electrical potential as the male and female connector parts.

An isolating part 80 encloses the first conductive shield 70. The isolating part may be at least partly tubular. A first isolating cap 82 may be arranged covering the first power interface 60. A second isolating cap 84 may be arranged covering the second power interface 62. The first and second isolating caps 82, 84 may comprise the same material as the isolating part 80.

The isolating part 80 may comprise a suitable isolating polymer which is at least slightly flexible. The polymer may comprise an elastomer. The elastomer may be a flexible rubber material. The isolating part may comprise, or be made of, a fluoropolymer elastomer selected from the group of copolymers of terpolymers of tetrafluoroethylene (TFE), hexafluoropropylene (HFP), vinylidene fluoride (VDF or VF2), vinylidene fluoride (VDF), hexafluoropropylene (HFP), and perfluoromethylvinylether (PMVE). A suitable material is for instance selected marketed under the brand name Viton^{™} by DuPont de Nemours, Inc. (US). Viton is a fluoropolymer elastomer and synthetic rubber compound. It is a fluorinated hydrocarbon rubber product able to withstand challenging environments.

In the connector 40, the isolating part 80 may be at least partly compressed between the first module 42 and the second module 44, wherein arrows F schematically indicate a compression force F. The compression force F may result from, for instance, a suitable mechanism to mechanically connect the first module 42 to the second module 44. The mechanism may, for instance, comprise screws and bolts (not shown), and/or one or more clamps (not shown). The compression force F may be in the range of 1 to 100 pounds (lb) per linear inch of seal (about 18 to 1800 kg/m).

A second conductive shield 90 may enclosed the isolating part 80. The second conductive shield 90 may engage with a coating 52 of the first module 42 and/or with a coating 52 of the second module 44. A first conductive cap 92 may cover the first isolating cap 82. A second conductive cap 94 may cover the second isolating cap 84. The first conductive cap 92 may engage with a coating 52 of the first module 42. The second conductive cap 94 may engage a coating 52 of the second module 42. During operation, the coating layers 52 will be connected to a reference voltage, referred to as earth or ground. Due to the electrically conductive engagement with one of the coating layers 52, the second conductive shield 90 and the conductive caps 92, 94 will be at the same reference voltage as the coatings 52.

With reference to Figure 4, in an embodiment the first end cap 92 and/or the second end cap 94 may be provided with a first opening 96 and a second opening 98 respectively. The first isolating cap 82 and the second isolating cap 84 may, on one side or on opposite sides, be provided with a disc 102, 104, 106, 108. The discs 102, 104, 106, 108 are comprised of a conductive material and engage with the first end cap 92, the second end cap 94 or one of the coating layers 52 respectively. The discs 102, 104, 106, 108 can be made of a metallic substance. The discs can be deposited as a droplet on the isolating caps 82, 84.

Fig. 4 shows the connector placed inside a pressure chamber 100. Although schematically indicated by a square in Fig. 4, the pressure chamber 100 can have any size or shape. The chamber is typically suitable to change the pressure inside the chamber 100 from ambient pressure (about 1 bar or 10⁵ Pa) to an operating pressure of choice. As described above, said operating pressure may be a pressure lower than ambient pressure, and may refer to pressures in the order of 50 mbar (5 kPa) and below. Some parts of the apparatus may operate at pressures in the order of 0.1 to 0.01 mbar (10 to 1 Pa).

The wall of the chamber 100 may be referred to as a vacuum wall, providing an interface between an environment at ambient pressure (1 bar) and the vacuum (below 100 mbar) inside the chamber. The first and second opening 96, 98 allow to remove some of the air trapped in the connector 40 when a pressure inside the chamber 100 is reduced. The discs 102, 104, 106, 108 provide continuity of the electric polarity and field provided by the coating layers 52 and the end caps 92, 94.

The connector 40 of the disclosure may be constructed by providing an assembly of isolating part and inner conductive shield 70. The assembly is placed on either the male connector part 46 or female connector part 48. Next, the outer conductive shield 90 can be arranged enclosed the isolating part. The isolating caps 82, 84 are put in place, and covered by the end caps 92, 94 respectively.

The two modules or circuit boards 42, 44 are now pressed together with a predetermined force F, using available means such as bolts or clamps. Herein, the isolating part is compressed between the two respective modules 42, 44 to provide a seal. The end caps 92, 94 compress the isolating caps 82, 84 to provide a seal with respect to the modules.

In operation, the area in vacuum chamber 100 is first lowered from ambient (1 bar) to operating pressure. Herein, optional openings 96, 98 allow some air trapped in the connector 40 to escape. Otherwise, air potentially trapped in pockets of the connector 40 remains inside of the connector, due to the seal as provided by the isolating part 80. The material of the isolating part can be selected to have a leak rate (at the compression force F and dimensions as selected) which in practice is so low, that the leak rate can practically be considered to be about 0. A low leak rate herein refers to, for instance, a rate below about 10⁻⁷ or 10⁻⁸ mbar·litre/sec per year. As described above, types of Viton^{™} by DuPont may be a suitable material to construct the isolating part. In a practical embodiment, SCVBR may be a suitable type of Viton.

Due to the electrical connection between the inner shield 70 and one or more of the male connector part 46, the female connector part 48 or one of the power interfaces 60, 62, the inner shield 70 is at the same electric potential. The isolating part basically obviates any air trapped inside the connector from escaping. At the same time, the isolating part surrounded by the outer shield, which is at the same reference voltage as the coatings 52, basically ground, ensure that the electrical connection inside the isolating part is electrically shielded from the environment. This means that air inside the connector stays inside, and is - due to the inner shield 70 - exposed to a uniform electric potential and field. Due to the isolating part and grounded shield 90, the electric connection is practically unaware of electrical connections outside the connection, thereby basically making Paschen breakdown impossible. Thus, the connector 40 of the disclosure advantageously enables operation over the entire range of pressures and voltages as exemplified in Figure 1. In practice, any air trapped inside the connector 40 will remain at 1 bar, while the pressure outside of the connector 40 may be lowered to a set operating pressure, for instance of about 50 mbar or lower.

The connector and method of the disclosure enable to operate while avoiding Paschen breakdown over the entire operating range as envisaged. The connector is avoids Paschen breakdown as envisaged including in vacuum (pressures of 100 mbar and lower, for instance in the range of 1 Pa to 5 kPa), high current (1 ampere and above, typically 10 to 60 A, for instance about 40 A), and high voltage (in the order of 0.5 to 4 kV, for instance about 1 kV). In addition, the connector is relatively simple, robust and cost-effective. As a result, production is relatively straightforward and the connector has a relatively long lifetime.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography. The connector and method of the disclosure are suitable for any application and apparatus requiring safe and reliable operation while avoiding Paschen breakdown.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the clauses set out below.
1. An electrical connector for a vacuum environment, the connector comprising:
   a male connection part configured to be connected to a first power interface,
   a female connection part for receiving the male connection part and configured to be connected to a second power interface,
   a first conductive shield enclosing the male connection part and the female connection part, the first conductive shield being electrically connected to at least one of the male connection part and the female connection part, and
   an isolating part enclosing the first conductive shield.
2. The connector of clause 1, comprising a second conductive shield enclosing the isolating part.
3. The connector of clause 2, comprising a first end cap at least partly enclosing the first power interface, and a second end cap at least partly enclosing the second power interface.
4. The connector of clause 3, wherein the first end cap and the second end cap together with the second conductive shield form an electrically closed enclosure of the male connection part, the female connection part, the first conductive shield and the isolating part.
5. The connector of any one of the previous clauses, the first conductive shield being a metallic tubular shield.
6. The connector of clause 5, the isolating part being a tubular polymer element.
7. The connector of clause 6, the polymer comprising a flexible rubber material.
8. The connector of any one of the previous clauses, the isolating part comprising a fluoropolymer elastomer selected from the group of copolymers of terpolymers of tetrafluoroethylene (TFE), hexafluoropropylene (HFP), vinylidene fluoride (VDF or VF2), vinylidene fluoride (VDF), hexafluoropropylene (HFP), and perfluoromethylvinylether (PMVE).
9. The electrical connector of any one of the previous clauses, suitable for a voltage exceeding 0.5 kV, or a voltage in the order of 1 kV or more.
10. The electrical connector of any one of the previous clauses, suitable for current exceeding 10 A, or current in the order of 40A or more.
11. A lithographic system comprising the electrical connector of clause 1.
12. The lithographic system of clause 11, comprising at least a first module having the first power interface, and a second module comprising the second power interface, the electrical connector electrically connecting the first module and the second module.
13. A method for providing an electrical connector for a vacuum environment, the method comprising the steps of:
   providing a first power interface and a male connection part connected to the first power interface,
   providing a second power interface and a female connection part connected to the second power interface,
   enclosing one of the male connection part or the female connection part with a first conductive shield,
   enclosing the first conductive shield with an isolating part,
   connecting the male connection part to the female connection part, wherein the first conductive shield is in electric communication with the first power interface and with the second power interface.
14. The method of clause 13, comprising the step of enclosing the isolating part with a second conductive shield.
15. The method of clause 14, comprising the step of arranging a first end cap at least partly enclosing the first power interface, and arranging a second end cap at least partly enclosing the second power interface.
16. The method of clause 13, the step of connecting the male connection part to the female connection part comprising compressing the isolating part between the first power interface and the second power interface.
17. The method of clause 13, comprising the step of operating the connected male connection part and female connection part at a voltage exceeding 0.5 kV, for instance a voltage in the order of 1 kV or more, and/or a current exceeding 20 A, for instance a current in the order of 40A or more.

## Claims

1. An electrical connector for a vacuum environment, the connector comprising:
a male connection part configured to be connected to a first power interface,
a female connection part for receiving the male connection part and configured to be connected to a second power interface,
a first conductive shield enclosing the male connection part and the female connection part, the first conductive shield being electrically connected to at least one of the male connection part and the female connection part, and
an isolating part enclosing the first conductive shield.

2. The connector of claim 1, comprising a second conductive shield enclosing the isolating part.

3. The connector of claim 2, comprising a first end cap at least partly enclosing the first power interface, and a second end cap at least partly enclosing the second power interface.

4. The connector of claim 3, wherein the first end cap and the second end cap together with the second conductive shield form an electrically closed enclosure of the male connection part, the female connection part, the first conductive shield and the isolating part.

5. The connector of any one of the previous claims, the first conductive shield being a metallic tubular shield.

6. The connector of claim 5, the isolating part being a tubular polymer element.

7. The connector of claim 6, the polymer comprising a flexible rubber material.

8. The connector of any one of the previous claims, the isolating part comprising a fluoropolymer elastomer selected from the group of copolymers of terpolymers of tetrafluoroethylene (TFE), hexafluoropropylene (HFP), vinylidene fluoride (VDF or VF2), vinylidene fluoride (VDF), hexafluoropropylene (HFP), and perfluoromethylvinylether (PMVE).

9. The electrical connector of any one of the previous claims, suitable for a voltage exceeding 0.5 kV, or a voltage in the order of 1 kV or more.

10. The electrical connector of any one of the previous claims, suitable for current exceeding 10 A, or current in the order of 40A or more.

11. A lithographic system comprising the electrical connector of claim 1.

12. The lithographic system of claim 11, comprising at least a first module having the first power interface, and a second module comprising the second power interface, the electrical connector electrically connecting the first module and the second module.

13. A method for providing an electrical connector for a vacuum environment, the method comprising the steps of:
providing a first power interface and a male connection part connected to the first power interface,
providing a second power interface and a female connection part connected to the second power interface,
enclosing one of the male connection part or the female connection part with a first conductive shield,
enclosing the first conductive shield with an isolating part,
connecting the male connection part to the female connection part, wherein the first conductive shield is in electric communication with the first power interface and with the second power interface.

14. The method of claim 13, comprising the steps of enclosing the isolating part with a second conductive shield, arranging a first end cap at least partly enclosing the first power interface, and arranging a second end cap at least partly enclosing the second power interface.

15. The method of claim 13 or 14, wherein the step of connecting the male connection part to the female connection part comprising compressing the isolating part between the first power interface and the second power interface.
